# EUROPEAN PATENT APPLICATION

(11) **EP 4 475 517 A1**
(43) Date of publication of application: **11.12.2024**
(21) Application number: 23776806.4
(22) Date of filing: 22.08.2023
(51) Int. Cl.: H04M 1/02, F16C 11/04, G06F 1/16, H05K 7/20

(54) **ELECTRONIC DEVICE COMPRISING STIFFENER**

(30) Priority: 30.09.2022 KR 20220125862; 31.10.2022 KR 20220143154
(71) Applicant: Samsung Electronics Co., Ltd., Suwon-si, Gyeonggi-do 16677 (KR)
(72) Inventor: RHEE, Bongjae, Suwon-si, Gyeonggi-do 16677 (KR)
(74) Representative: Nederlandsch Octrooibureau
(86) International application number: PCT/KR2023/012444
(87) International publication number: WO 2024/071688

(57) **Abstract**

The electronic device according to an embodiment includes a first housing, a second housing rotatable with respect to the first housing, a hinge structure, a display, a heat dissipation sheet, a stiffener disposed between a portion of the display and the hinge structure and providing rigidity to the display, and a fixing structure pressed by the hinge structure in a folding state. The stiffener is flat in an unfolding state in which the first direction and the second direction are the same, and at least a portion of the stiffener is bent by the force applied to the fixing structure from the hinge structure in the folding state. In addition to this, various embodiments are possible.

## Description

### [Technical Field]

Various embodiments of the present disclosure relate to an electronic device including a stiffener.

### [Background Art]

An electronic device including a large-screen display may increase user utilization. As the demand for the electronic device having high portability increases, the electronic device may include a deformable display. The deformable display may be deformable by sliding, by folding, or by rolling.

The above-described information may be provided as related art for the purpose of helping understanding of the present disclosure. No claim or determination is raised as to whether any of the above-described contents may be applied as a prior art in connection with the present disclosure.

### [Disclosure]

### [Technical Solution]

An electronic device according to an embodiment may comprise a first housing, a second housing, a hinge structure, a display, a heat dissipation sheet, a stiffener, and a fixing structure. The first housing may comprise a first surface. The second housing may comprise a second surface. The second housing may be rotatable with respect to the first housing. The hinge structure may comprise a first hinge plate and a second hinge plate. The second hinge plate may be rotatable with respect to the first hinge plate. The display may include a first display area, a second display area, and a third display area. The first display area may be disposed on the first housing. The second display area may be disposed on the second housing. The third display area may be disposed on the hinge structure. The heat dissipation sheet may include a first segment, a second segment, and a third segment. The first segment may be disposed between the first display area and the first surface. The second segment may be disposed between the second display area and the second surface. The third segment may be disposed between the third display area and the hinge structure. The stiffener may be disposed between the third display area and the hinge structure. The stiffener may provide rigidity to the third display area. The fixing structure may be connected to the stiffener. The fixing structure may be pressed by the first hinge plate and the second hinge plate in a folding state in which a first direction towards which the first surface is directed and a second direction towards which the second surface are directed are opposite. The stiffener may be flat in an unfolding state in which the first direction and the second direction are the same. At least a portion of the stiffener may be bent by the force applied to the fixing structure from the first hinge plate and the second hinge plate in the folding state.

An electronic device according to an embodiment may comprise a first housing, a second housing, a hinge structure, a display, a flexible printed circuit board, a stiffener, and a fixing structure. The first housing may comprise a first surface. The second housing may comprise a second surface. The second housing may be rotatable with respect to the first housing. The hinge structure may comprise a hinge bracket, a first hinge plate, and a second hinge plate. The hinge bracket may comprise a first guide groove and a second guide groove. The first hinge plate may be slidably connected to the first guide groove. The second hinge plate may be slidably connected to the second guide groove. The display may comprise a first display area, a second display area, and a third display area. The first display area may be disposed on the first housing. The second display area may be disposed on the second housing. The third display area may be disposed on the hinge structure. The flexible printed circuit board may comprise a first segment, a second segment, and a third segment. The first segment may extend from a first printed circuit board in the first housing to between the first display area and the first surface. The second segment may extend from a second printed circuit board in the second housing to between the second display area and the second surface. The third segment may be disposed between the first segment and the second segment. The third segment may be disposed between the third display area and the hinge structure. The stiffener may be disposed between the third display area and the hinge structure. The stiffener may provide rigidity to the third display area. The fixing structure may be connected to the stiffener. The fixing structure may be pressed by the first hinge plate and the second hinge plate in a folding state in which a first direction towards which the first surface is directed and a second direction towards which the second surface are directed are opposite. The stiffener may be flat in an unfolding state in which the first direction and the second direction are the same. At least a portion of the stiffener may be bent by the force applied to the fixing structure from the first hinge plate and the second hinge plate in the folding state.

### [Description of the Drawings]

FIG. 1 is a block diagram of an electronic device in a network environment according to an embodiment.
FIG. 2A illustrates an unfolding state of an exemplary electronic device.
FIG. 2B illustrates a folding state of an exemplary electronic device.
FIG. 2C is an exploded view of an exemplary electronic device.
FIG. 3 schematically illustrates an exemplary electronic device in an unfolding state.
FIG. 4 schematically illustrates an exemplary electronic device in a folding state.
FIG. 5A schematically illustrates an exemplary electronic device.
FIG. 5B is a plan view of an exemplary heat dissipation sheet.
FIG. 6 schematically illustrates an exemplary electronic device in an unfolding state.
FIG. 7 schematically illustrates an exemplary electronic device in a folding state.

### [Mode for Invention]

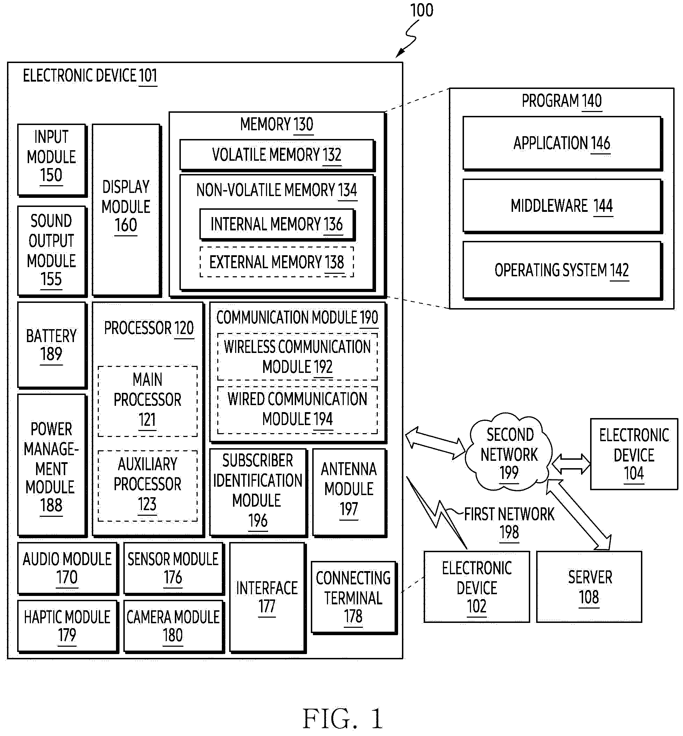

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

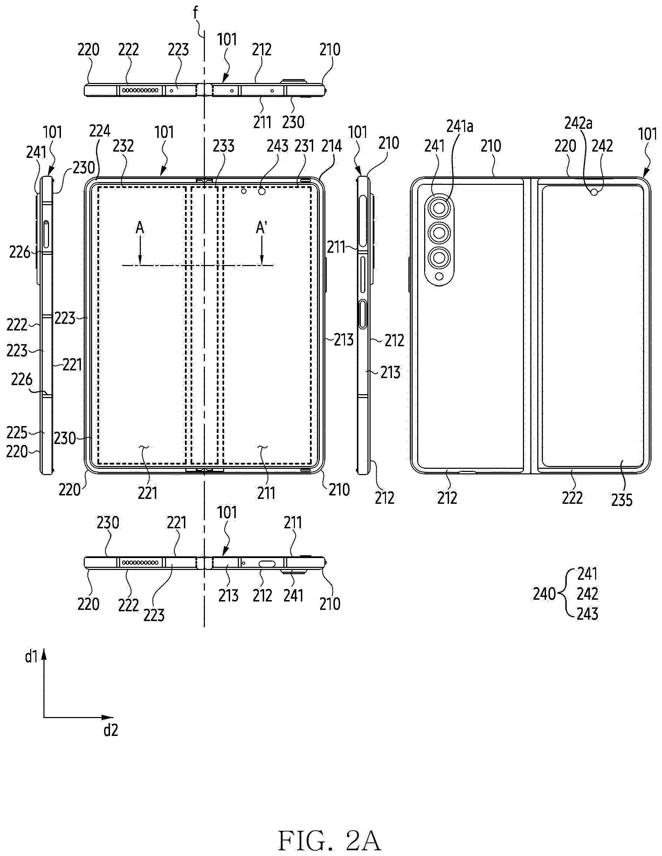

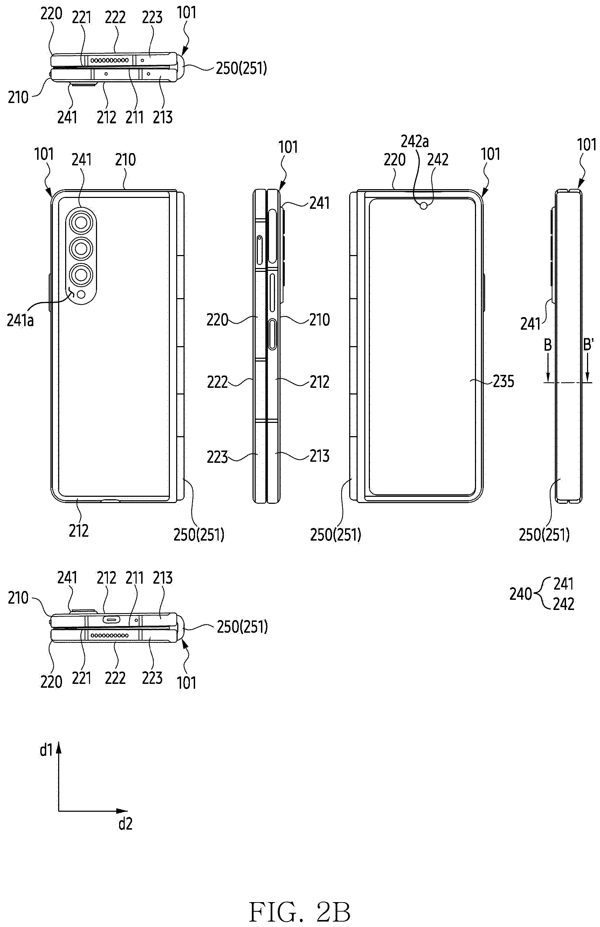

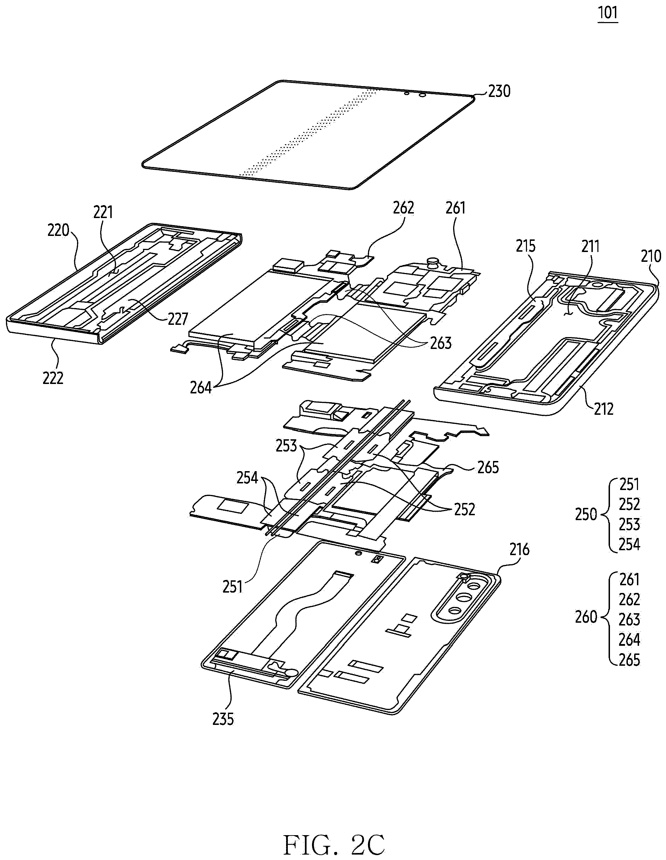

FIG. 2A illustrates an unfolding state of an exemplary electronic device. FIG. 2B illustrates a folding state of an exemplary electronic device. FIG. 2C is an exploded view of an exemplary electronic device.

Referring to FIGS. 2A, 2B, and 2C, the electronic device (e.g., an electronic device 101 of FIG. 1) may include a first housing 210, a second housing 220, and a display 230 (e.g., a display module 160 of FIG. 1), at least one camera 240 (e.g., a camera module 180 of FIG. 1), a hinge structure 250, and/or at least one electronic component 260.

The first housing 210 and the second housing 220 may form at least a portion of an outer surface of the electronic device 101 that may be gripped by a user. At least a portion of the outer surface of the electronic device 101 defined by the first housing 210 and the second housing 220 may be in contact with a portion of the user's body when the electronic device 101 is used by the user. According to an embodiment, the first housing 210 may include a first surface 211, a second surface 212 facing the first surface 211 and spaced apart from the first surface 211, and a first side surface 213 surrounding at least a portion of the first surface 211 and the second surface 212. The first side surface 213 may connect the periphery of the first surface 211 and the periphery of the second surface 212. The first surface 211, the second surface 212, and the first side surface 213 may define an inner space of the first housing 210. According to an embodiment, the first housing 210 may provide a space formed by the first surface 211, the second surface 212, and the first side surface 213 as a space for disposing the at least one component 260 of the electronic device 101.

According to an embodiment, the second housing 220 may include a third surface 221, a fourth surface 222 facing the third surface 221 and spaced apart from the third surface 221, and a second side surface 223 surrounding at least a portion of the third surface 221 and the fourth surface 222. The second side surface 223 may connect the periphery of the third surface 221 and the periphery of the fourth surface 222. The third surface 221, the fourth surface 222, and the second side surface 223 may define an inner space of the second housing 220. According to an embodiment, the second housing 220 may provide a space formed by the third surface 221, the fourth surface 222, and the second side surface 223 surrounding at least a portion of the third surface 221 and the fourth surface 222 as a space for mounting the at least one component 260 of the electronic device 101. According to an embodiment, the second housing 220 may be coupled to the first housing 210 so that the second housing 220 is rotatable with respect to the first housing 210.

According to an embodiment, each of the first housing 210 and the second housing 220 may include a first protection member 214 and a second protection member 224, respectively. The first protection member 214 and the second protection member 224 may be disposed on the first surface 211 and the third surface 221 along the periphery of the display 230. According to an embodiment, the first protection member 214 and the second protection member 224 may prevent the inflow of foreign substances (e.g., dust or moisture) through the gap between the display 230 and the first housing 210 and the second housing 220. For example, the first protection member 214 may surround the periphery of a first display area 231 of the display 230, and the second protection member 224 may surround the periphery of a second display area 232 of the display 230. The first protection member 214 may be formed by being attached to the first side surface 213 of the first housing 210 or integrally formed with the first side surface 213. The second protection member 224 may be formed by being attached to the second side surface 223 of the second housing 220 or integrally formed with the second side surface 223.

According to an embodiment, the first side surface 213 and the second side surface 223 may include a conductive material, a non-conductive material, or a combination thereof. For example, the second side surface 223 may include at least one conductive member 225 and at least one non-conductive member 226. The at least one conductive member 225 may include a plurality of conductive members spaced apart from each other. The at least one non-conductive member 226 may be disposed between the plurality of conductive members. The plurality of conductive members may be disconnected from each other by the at least one non-conductive member 226 disposed between the plurality of conductive members. According to an embodiment, the plurality of conductive members and the plurality of non-conductive members may together form an antenna radiator. The electronic device 101 may be capable of communicating with an external electronic device through the antenna radiator formed by the plurality of conductive members and the plurality of non-conductive members.

The display 230 may be configured to display visual information. According to the embodiment, the display 230 may be disposed on the first surface 211 of the first housing 210 and the third surface 221 of the second housing 220 across the hinge structure 250. For example, the display 230 may include the first display area 231 disposed on the first surface 211 of the first housing, the second display area 232 disposed on the third surface 221 of the second housing, and the third display area 233 disposed between the first display area 231 and the second display area 232. The first display area 231, the second display area 232, and the third display area 233 may form a front surface of the display 230. According to an embodiment, the display 230 may further include a sub-display panel 235 disposed on the fourth surface 222 of the second housing 220. For example, the display 230 may be referred to as a flexible display. According to an embodiment, the display 230 may include a window exposed toward the outside of the electronic device 101. The window may protect the surface of the display 230 and include substantially transparent materials, thereby transmitting the visual information provided by the display 230 to the outside of the electronic device 101. For example, the window may include glass (e.g., UTG, ultra-thin glass) and/or polymer (e.g., PI, polyimide), but is not limited thereto.

The at least one camera 240 may be configured to obtain an image based on receiving light from a subject outside the electronic device 101. According to an embodiment, the at least one camera 240 may include first cameras 241, a second camera 242, and a third camera 243. The first cameras 241 may be disposed in the first housing 210. For example, the first cameras 241 may be disposed inside the first housing 210 and at least portion of them may be visible through the second surface 212 of the first housing 210. The first cameras 241 may be supported by a bracket (not illustrated) in the first housing 210. The first housing 210 may include at least one opening 241a overlapping the first cameras 241 when the electronic device 101 is viewed from above. The first cameras 241 may obtain the image based on receiving light from the outside of the electronic device 101 through the at least one opening 241a.

According to an embodiment, the second camera 242 may be disposed in the second housing 220. For example, the second camera 242 may be disposed inside the second housing 220 and may be visible through the sub-display panel 235. The second housing 220 may include at least one opening 242a overlapping the second camera 242 when the electronic device 101 is viewed from above. The second camera 242 may obtain the image based on receiving light from the outside of the electronic device 101 through the at least one opening 242a.

According to an embodiment, the third camera 243 may be disposed in the first housing 210. For example, the third camera 243 may be disposed inside the first housing 210, and at least a portion of it may be visible through the first surface 211 of the first housing 210. For another example, the third camera 243 may be disposed inside the first housing 210, and at least a portion of it may be visible through the first display area 231 of the display 230. The first display area 231 of the display 230 may include at least one opening overlapping the third camera 243 when the display 230 is viewed from above. The third camera 243 may obtain the image based on receiving light from the outside of the display 230 through the at least one opening.

According to an embodiment, the second camera 242 and the third camera 243 may be disposed below (e.g., a direction toward the inside of the first housing 210 or the inside of the second housing 220) the display 230. For example, the second camera 242 and the third camera 243 may be an under display camera (UDC). In case that the second camera 242 and the third camera 243 are the under display cameras, one area of the display 230 corresponding to each position of the second camera 242 and the third camera 243 may not be an inactive area. The inactive area of the display 230 may mean the one area of the display 230 that does not include pixels or does not emit light to the outside of the electronic device 101. For another example, the second camera 242 and the third camera 243 may be punch hole cameras. In case that the second camera 242 and the third camera 243 are the punch hole cameras, the one area of the display 230 corresponding to each position of the second camera 242 and the third camera 243 may be the inactive area.

According to an embodiment, the hinge structure 250 may rotatably connect the first housing 210 and the second housing 220. The hinge structure 250 may be disposed between the first housing 210 and the second housing 220 of the electronic device 101 so that the electronic device 101 may be bent, curved, or folded. For example, the hinge structure 250 may be disposed between a portion of the first side surface 213 and a portion of the second side surface 223 facing each other. The hinge structure 250 may change the electronic device 101 to the unfolding state in which the direction toward which the first surface 211 of the first housing 210 and the third surface 221 of the second housing 220 are directed are the same or the folding state in which the first surface 211 and the third surface 221 face each other. When the electronic device 101 is in the folding state, the first housing 210 and the second housing 220 may be stacked or overlapped by facing each other.

According to an embodiment, when the electronic device 101 is in the folding state, the direction toward which the first surface 211 is directed and the direction toward which the third surface 221 is directed may be different from each other. For example, when the electronic device 101 is in the folding state, the direction toward which the first surface 211 is directed and the direction toward which the third surface 221 is directed may be opposite to each other. For another example, when the electronic device 101 is in the folding state, the direction toward which the first surface 211 is directed and the direction toward which the third surface 221 is directed may be inclined with respect to each other. In case that the direction toward which the first surface 211 is directed is inclined with respect to the direction toward which the third surface 221 is directed, the first housing 210 may be inclined with respect to the second housing 220.

According to an embodiment, the electronic device 101 may be foldable based on a folding axis f. The folding axis f may mean a virtual line extending while passing through a hinge cover 251 in a direction (e.g., d1 of FIGS. 2A and 2B) parallel to the longitudinal direction of the electronic device 101, but is not limited thereto. For example, the folding axis f may be a virtual line extending in a direction (e.g., d2 of FIGS. 2A and 2B) perpendicular to the longitudinal direction of the electronic device 101. In case that the folding axis f extends in the direction perpendicular to the longitudinal direction of the electronic device 101, the hinge structure 250 may extend in a direction parallel to the folding axis f to connect the first housing 210 and the second housing 220. The first housing 210 and the second housing 220 may be rotatable by the hinge structure 250 extending in the direction perpendicular to the longitudinal direction of the electronic device 101.

According to an embodiment, the hinge structure 250 may include the hinge cover 251, a first hinge plate 252, a second hinge plate 253, and a hinge module 254. The hinge cover 251 may surround internal components of the hinge structure 250 and may form an outer surface of the hinge structure 250. According to an embodiment, when the electronic device 101 is in the folding state, at least a portion of the hinge cover 251 surrounding the hinge structure 250 may be exposed to the outside of the electronic device 101 through between the first housing 210 and the second housing 220. According to an embodiment, when the electronic device 101 is in the unfolding state, the hinge cover 251 may not be exposed to the outside of the electronic device 101 by being covered by the first housing 210 and the second housing 220.

According to an embodiment, the first hinge plate 252 and the second hinge plate 253 may be coupled to the first housing 210 and the second housing 220, respectively, thereby rotatably connecting the first housing 210 and the second housing 220. For example, the first hinge plate 252 may be coupled to a first front bracket 215 of the first housing 210, and the second hinge plate 253 may be coupled to a second front bracket 227 of the second housing 220. As the first hinge plate 252 and the second hinge plate 253 are coupled to the first front bracket 215 and the second front bracket 227, respectively, the first housing 210 and the second housing 220 may be rotatable according to the rotation of the first hinge plate 252 and the second hinge plate 253.

The hinge module 254 may rotate the first hinge plate 252 and the second hinge plate 253. For example, the hinge module 254 may rotate the first hinge plate 252 and the second hinge plate 253 based on the folding axis f by including rotatable gears engaged with each other. According to an embodiment, the hinge module 254 may be plural. For example, each of the plurality of hinge modules 254 may be spaced apart from each other and disposed at both ends of the first hinge plate 252 and the second hinge plate 253.

According to an embodiment, the first housing 210 may include the first front bracket 215 and a rear bracket 216, and the second housing 220 may include the second front bracket 227. The first front bracket 215 and the rear bracket 216 may be disposed inside the first housing 210 and may support the at least one component 260 of the electronic device 101. The second front bracket 227 may be disposed inside the second housing 220 and may support the at least one component 260 of the electronic device 101. For example, the display 230 may be disposed on one surface of the first front bracket 215 and one surface of the second front bracket 227. The rear bracket 216 may be disposed on the other surface of the first front bracket 215 facing the one surface of the first front bracket 215.

According to an embodiment, a portion of the first front bracket 215 may be surrounded by the first side surface 213, and a portion of the second front bracket 227 may be surrounded by the second side surface 223. For example, the first front bracket 215 may be integrally formed with the first side surface 213, and the second front bracket 227 may be integrally formed with the second side surface 223. For another example, the first front bracket 215 may be formed separately from the first side surface 213, and the second front bracket 227 may be formed separately from the second side surface 223.

The at least one electronic component 260 may implement various functions for providing to the user. According to an embodiment, the at least one electronic component 260 may include a first printed circuit board 261, a second printed circuit board 262, a flexible printed circuit board 263, a battery 264 (e.g., a battery 189 of FIG. 1) and/or an antenna 265 (e.g., an antenna module 197 of FIG. 1). The first printed circuit board 261 and the second printed circuit board 262 may form an electrical connection of components in the electronic device 101, respectively. For example, components (e.g., a processor 120 of FIG. 1) for implementing overall functions of the electronic device 101 may be disposed on the first printed circuit board 261, and electronic components for implementing some functions of the first printed circuit board 261 may be disposed on the second printed circuit board 262. For another example, components for the operation of the sub-display panel 235 disposed on the fourth surface 222 may be disposed on the second printed circuit board 262.

According to an embodiment, the first printed circuit board 261 may be disposed in the first housing 210. For example, the first printed circuit board 261 may be disposed on the one surface of the first front bracket 215. According to an embodiment, the second printed circuit board 262 may be disposed in the second housing 220. For example, the second printed circuit board 262 may be spaced apart from the first printed circuit board 261 and disposed on the one surface of the second front bracket 227. The flexible printed circuit board 263 may connect the first printed circuit board 261 and the second printed circuit board 262. For example, the flexible printed circuit board 263 may extend from the first printed circuit board 261 to the second printed circuit board 262.

The battery 264 is a device for supplying power to the at least one component 260 of the electronic device 101, and may include, for example, a non-rechargeable primary battery, a rechargeable secondary battery, or a fuel cell. At least a portion of the battery 264 may be disposed substantially on the same plane as the first printed circuit board 261 or the second printed circuit board 262.

The antenna 265 may be configured to receive power or a signal from the outside of the electronic device 101. According to an embodiment, the antenna 265 may be disposed between the rear bracket 216 and the battery 264. The antenna 265 may include, for example, a near field communication (NFC) antenna, an antenna module, and/or a magnetic secure transmission (MST) antenna. The antenna 265 may, for example, perform short-range communication with an external device or wirelessly transmit/receive power required for charging.

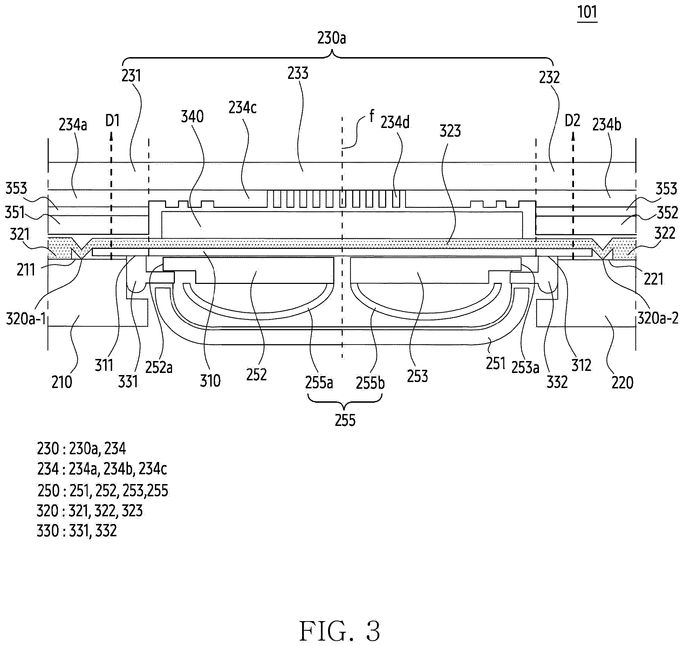

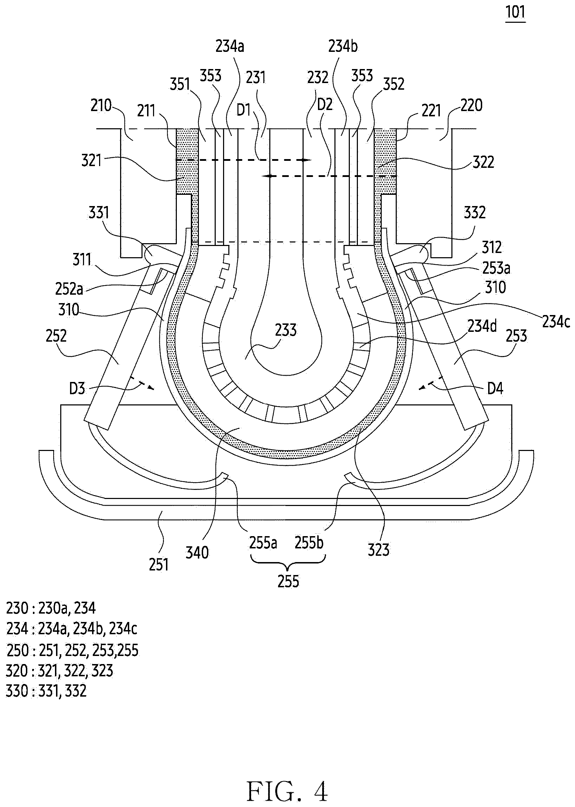

FIG. 3 is a cross-sectional view of an exemplary electronic device in an unfolding state cut along A-A' of FIG. 2A. FIG. 4 is a cross-sectional view of an exemplary electronic device in a folding state cut along B-B' of FIG. 2B.

Referring to FIGS. 3, 4, and 5, an electronic device 101 according to an embodiment may include a first housing 210, a second housing 220, a hinge structure 250, a display 230, a heat dissipation sheet 320, a stiffener 310, and/or a fixing structure 330.

The electronic device 101 according to an embodiment may include a first housing 210 and a second housing 220 that may be folded or unfolded each other. The electronic device 101 according to an embodiment may be referred to as a foldable electronic device 101. The hinge structure 250 may enable the electronic device 101 to be switched to the folding state or the unfolding state by rotatably connecting the first housing 210 and the second housing 220 based on the folding axis f. For example, when a first direction D1 toward which a first surface 211 (e.g., a first surface 211 of FIG. 2A) of the first housing 210 is directed corresponds to a second direction D2 toward which a second surface 221 (e.g., a third surface 221 of FIG. 2A) of the second housing 220 is directed, the electronic device 101 may be referred to as the unfolding state. For example, when the first direction D1 is opposite to the second direction D2, the electronic device 101 may be referred to as the folding state. For example, when the electronic device 101 is in a state between the folding state and the unfolding state, the electronic device 101 may be referred to as an intermediate state. The hinge structure 250 may hold the positions of the first housing 210 and the second housing 220 so that an angle between the first housing 210 and the second housing 220 has a predetermined angle (e.g., 90 degrees) in the intermediate state. The predetermined angle may be greater than the angle between the first housing 210 and the second housing 220 in the folding state and may be less than the angle between the first housing 210 and the second housing 220 in the unfolding state.

Referring to FIG. 3, when the electronic device 101 is in the unfolding state, the first housing 210 and the second housing 220 may be disposed on substantially the same plane. For example, in the unfolding state, the first direction D1 and the second direction D2 may be the same. Referring to FIG. 4, when the electronic device 101 is in the folding state, the first housing 210 and the second housing 220 may face each other. For example, in the folding state, the first direction D1 and the second direction D2 may be opposite to each other. According to an embodiment, when the electronic device 101 is in the intermediate state, the first housing 210 and the second housing 220 may form the predetermined angle. For example, in the intermediate state, the first direction D 1 and the second direction D2 may form the predetermined angle.

According to an embodiment, the display 230 may be referred to as a flexible display in which at least a portion (e.g., a third display area 233) of the display 230 may be folded or unfolded. According to an embodiment, the display 230 may have flexibility. For example, the display 230 may include a folding area that may be folded by the movement of the first housing 210 or the movement of the second housing 220.

According to an embodiment, the display 230 may include a display panel 230a and a conductive plate 234. The display panel 230a may display visual information (e.g., multimedia data or text data) to a user. For example, the display panel 230a may include a display area for displaying the visual information. For example, the display panel 230a may include a first display area 231, a second display area 232, and the third display area 233. The first display area 231 may be disposed on the first surface 211 of the first housing 210. The second display area 232 may be disposed on the second surface 221 of the second housing 220. The third display area 233 may be disposed on the hinge structure 250. The third display area 233 may be referred to as the foldable fording area when the electronic device 101 is in the folding state.

According to an embodiment, the shape of the third display area 233 may be different depending on the state of the electronic device 101. Referring to FIG. 3, the third display area 233 may be substantially flat in the unfolding state. Referring to FIG. 4, in the folding state, the third display area 233 may be bent. Although not illustrated, the display 230 may include a window (e.g., polyimide (PI) film, ultra-thin glass (UTG)) disposed on the display panel 230a.

According to an embodiment, the conductive plate 234 may be disposed on a surface (e.g., a rear surface) opposite to the surface directing the outside of the display 230. For example, the conductive plate 234 may be disposed on the rear surface of the display panel 230a. The conductive plate 234 may provide rigidity to the display 230 by supporting the display panel 230a. The conductive plate 234 may shield noise. For example, the conductive plate 234 may be a sheet including a conductive material (e.g., metal). The conductive plate 234 may include a first portion 234a corresponding to the first display area 231, a second portion 234b corresponding to the second display area 232, and a third portion 234c corresponding to the third display area 233. The first portion 234a may be disposed under the first display area 231, the second portion 234b may be disposed under the second display area 232, and the third portion 234c may be disposed under the third display area 233. At least a portion of the third portion 234c may be bent in the folding state. The third portion 234c may include a pattern 234d. For example, the pattern 234d may be a lattice structure including a plurality of openings and/or a plurality of recesses. When the electronic device 101 is in the folding state, the third portion 234c may be bent through the pattern 234d.

The electronic device 101 according to an embodiment may include a first support plate 351 and a second support plate 352 for supporting a portion of the display 230. The first support plate 351 may be disposed between the first display area 231 and the first surface 211. The second support plate 352 may be disposed between the second display area 232 and the second surface 221. For example, the first support plate 351 may be adhered to the first portion 234a through an adhesive member 353. For example, the second support plate 352 may be adhered to the second portion 234b through the adhesive member 353. For example, the adhesive member 353 may include at least one of an optical clear adhesive (OCA), a pressure sensitive adhesive (PSA), a thermal reaction adhesive, a general adhesive, or a tape, but is not limited thereto. The first support plate 351 may support the first display area 231, and the second support plate 352 may support the second display area 232. The first support plate 351 and the second support plate 352 may be spaced apart from each other. The first support plate 351 and the second support plate 352 may support the first display area 231 and the second display area 232 which are in a planar shape in order to reinforce the rigidity of the display 230.

According to an embodiment, the first support plate 351 and the second support plate 352 may be rigid in order to support the first display area 231 and the second display area 232, respectively. Since the third display area 233 is bent in the folding state, the support plate may be omitted in an area corresponding to the third display area 233. Since the support plate is omitted in the area corresponding to the third display area 233, a step may be formed between the first support plate 351 and the second support plate 352. The electronic device 101 according to an embodiment may include a leveler 340 to compensate for the step. For example, the leveler 340 may include a film having a thickness in order to compensate for the step, but is not limited thereto. The leveler 340 may be disposed between the first support plate 351 and the second support plate 352. The leveler 340 may reduce the occurrence of wrinkles in the third display area 233 as the electronic device 101 is repeatedly folded and unfolded. For example, the leveler 340 may be flexible. Reducing the occurrence of the wrinkles in the third display area may contribute to reducing the stress of a part where said display is deformed. In that way, the durability of the display can be improved.

According to an embodiment, the hinge structure 250 may include a hinge cover 251, a hinge bracket 255, a first hinge plate 252, and a second hinge plate 253. The hinge cover 251 may define an outer surface of the hinge structure 250. For example, the hinge cover 251 may surround the hinge bracket 255, the first hinge plate 252, and the second hinge plate 253. When the electronic device 101 is in the unfolding state, the hinge cover 251 may be covered by the first housing 210 and the second housing 220. When the electronic device 101 is in the folding state, the hinge cover 251 may be exposed between the first housing 210 and the second housing 220.

For example, the hinge bracket 255 may support the first hinge plate 252 and the second hinge plate 253. The hinge bracket 255 may be coupled to the first hinge plate 252 and the second hinge plate 253. For example, the first hinge plate 252 may be coupled to the first guide groove 255a of the hinge bracket 255 and may be rotatable along the first guide groove 255a. The second hinge plate 253 may be coupled to a second guide groove 255b distinct from the first guide groove 255a and may be rotatable along the second guide groove 255b.

According to an embodiment, a stiffener 310 may provide rigidity to the third display area 233. Since the conductive plate 234 includes a pattern in a third portion corresponding to the third display area 233, it may be insufficient to provide rigidity to resist an external force applied to the third display area 233. Since the third display area 233 overlaps between the first support plate 351 and the second support plate 352, the first support plate 351 and the second support plate 352 may support only the first display area 231 and the second display area 232. Referring to FIG. 3, the stiffener 310 may be disposed between the third display area 233 and the hinge structure 250. In order to provide rigidity to the third display area 233, the stiffener 310 may be positioned to overlap the third display area 233. For example, when the electronic device 101 is viewed from the display 230 toward the hinge cover 251, the third display area 233 and the stiffener 310 may at least partially overlap. For example, the stiffener 310 may be a stainless steel (SUS) plate having a thin thickness, but is not limited thereto.

According to an embodiment, the fixing structure 330 may be configured to press the stiffener 310 when the electronic device 101 is in the folding state. Referring to FIG. 3, the fixing structure 330 may be connected to the stiffener 310. For example, the fixing structure 330 may be attached to the stiffener 310 by an adhesive between the fixing structure 330 and the stiffener 310, but is not limited thereto. For example, the fixing structure 330 and the stiffener 310 may be physically fastened. The fixing structure 330 may be spaced apart from the first hinge plate 252 and the second hinge plate 253 in the unfolding state. The fixing structure 330 may be pressed by the first hinge plate 252 and the second hinge plate 253 by being in contact with the first hinge plate 252 and the second hinge plate 253 in the folding state.

According to an embodiment, the stiffener 310 may provide rigidity to the third display area 233 by having a shape corresponding to the third display area 233. For example, the fixing structure 330 may include a first fixing structure 331 and a second fixing structure 332 coupled to the stiffener 310. The first fixing structure 331 may be disposed between the first housing 210 and the first hinge plate 252. The second fixing structure 332 may be disposed between the second housing 220 and the second hinge plate 253. The first fixing structure 331 may be coupled to a first portion 311 of the stiffener 310. The second fixing structure 332 may be coupled to a second portion 312 spaced apart from the first portion 311 of the stiffener 310. Referring to FIG. 3, in the unfolding state, the first fixing structure 331 may be spaced apart from the first hinge plate 252, and the second fixing structure 332 may be spaced apart from the second hinge plate 253. For example, in the unfolding state, the first fixing structure 331 may be spaced apart from a side surface 252a facing the first fixing structure 331 of the first hinge plate 252. For example, the second fixing structure 332 may be spaced apart from a side surface 253a facing the second fixing structure 332 of the second hinge plate 253. In the unfolding state, the stiffener 310 may be flat.

Referring to FIG. 4, as the electronic device 101 changes from the unfolding state to the folding state, the first hinge plate 252 and the second hinge plate 253 may rotate. For example, as the electronic device 101 changes from the unfolding state to the folding state, the first hinge plate 252 may move along the first guide groove 225a, and the second hinge plate 253 may move along the second guide groove 225b. In the folding state, the first hinge plate 252 and the second hinge plate 253 may be in contact with the fixing structure 330. For example, in the folding state, the side surface 252a facing the first fixing structure 331 of the first hinge plate 252 may be in contact with the first fixing structure 331. For example, the side surface 253a facing the second fixing structure 332 of the second hinge plate 253 may be in contact with the second fixing structure 332. In the folding state, the first fixing structure 331 may be pressed by the first hinge plate 252 in contact with the first fixing structure 331, and the second fixing structure 332 may be pressed by the second hinge plate 253 in contact with the second fixing structure 332. In the folding state, a force provided from the first hinge plate 252 to the first fixing structure 331 and a force provided from the second hinge plate 253 to the second fixing structure 332 may be transmitted to the stiffener 310. For example, as the first hinge plate 252 presses the first fixing structure 331, the first fixing structure 331 may press the first portion 311. As the second hinge plate 253 presses the second fixing structure 332, the second fixing structure 332 may press the second portion 312. The stiffener 310 may be bent without being substantially elongated by the force that presses the first portion 311 and the force that presses the second portion 312. The stiffener 310 may provide rigidity under the third display area 233 of the display 230.

According to an embodiment, the stiffener 310 may reduce damage to the third display area 233 by providing rigidity to the third display area 233. For example, when the external force is applied to the third display area 233, the stiffener 310 may reduce damage to the third display area 233 by providing rigidity that resists the external force under the third display area 233. When the shape of the third display area 233 is changed according to the state of the electronic device 101, the stiffener 310 may effectively provide rigidity to the third display area 233 by having a shape corresponding to the shape of the third display area 233. The shape of the stiffener 310 may be deformed by the first hinge plate 252, the second hinge plate 253, and the fixing structure 330 independently of the display 230. Since the shape of the stiffener 310 may be deformed independently of the display 230, it may be deformed regardless of the shape of the display 230. For example, when the electronic device 101 changes from the unfolding state to the folding state, the stiffener 310 may be bent by being pressed by the fixing structure 330. When the electronic device 101 changes from the folding state to the unfolding state, the stiffener 310 may be flattened again by the restoring force. According to an embodiment, the stiffener 310 may provide rigidity to the third display area 233 by being deformed corresponding to the shape of the display 230. The shape of the stiffener 310 may be deformed independently of the display 230.

According to an embodiment, the heat dissipation sheet 320 may be configured to dissipate heat generated from the display 230. For example, the heat dissipation sheet 320 may be configured to dissipate heat generated from the display 230 to the outside. The heat dissipation sheet 320 may diffuse heat concentrated in a specific area of the display 230 to the entire area of the display 230. For example, the heat dissipation sheet 320 may be configured to diffuse heat generated from some areas (e.g., the first display area 231) of the display 230 to other areas (e.g., the second display area 232) of the display 230. The heat dissipation sheet 320 may include a material having high thermal conductivity in order to diffuse heat. For example, the heat dissipation sheet 320 may include graphite and/or copper, but is not limited thereto.

According to an embodiment, the shape of the heat dissipation sheet 320 may correspond to the shape of the display 230. The heat dissipation sheet 320 may be adhered to the stiffener 310. For example, the heat dissipation sheet 320 may include a first segment 321, a second segment 322, and a third segment 323. The second segment 322 may be spaced apart from the first segment 321. For example, the first segment 321 may be disposed between the first surface 211 and the first support plate 351. The second segment 322 may be disposed between the second surface 221 and the second support plate 352. The third segment 323 may be disposed between the first segment 321 and the second segment 322.

According to an embodiment, the first segment 321 may correspond to the first display area 231, and the second segment 322 may correspond to the second display area 232. For example, the first segment 321 may be disposed between the first surface 211 and the display 230. For example, the second segment 322 may be disposed between the second surface 221 and the display 230. The third segment 323 may extend from the first segment 321 across the hinge structure 250 to the second segment 322. According to an embodiment, the third segment 323 may overlap the hinge structure 250. "Overlapping the hinge structure 250" may mean that the third segment 323 and the hinge structure 250 are disposed in the same area when the heat dissipation sheet 320 is viewed from above. The third segment 323 may thermally connect the first segment 321 and the second segment 322. For example, the heat generated in the first display area 231 may be transmitted to the first segment 321 corresponding to the first display area 231, and may be transmitted to the second segment 322 through the third segment 323.

Referring to FIG. 3, the first segment 321, the second segment 322, and the third segment 323 may be disposed on substantially the same plane in the unfolding state. Since the first segment 321 and the second segment 322 form substantially the same plane in the unfolding state, the first segment 321, the second segment 322, and the third segment 323 may be flat.

Referring to FIG. 4, when changing from the unfolding state to the folding state, the heat dissipation sheet 320 may be folded based on the folding axis f. As the electronic device 101 changes from the unfolding state to the folding state, at least a portion of the third segment 323 overlapping the hinge structure 250 may be bent. According to an embodiment, in the folding state, the third segment 323 may receive tensile stress from the first segment 321 and the second segment 322. Since the third segment 323 is bent in the folding state, a first force in a direction toward the first segment 321 may be applied to a portion of the third segment 323 connected to the first segment 321, and a second force in a direction toward the second segment 322 may be applied to a portion of the third segment 323 connected to the second segment 322.

According to an embodiment, the heat dissipation sheet 320 may include folding portions 320a-1 and 320a-2 to compensate for the first force and the second force. For example, when the electronic device 101 is in the unfolding state, the folding portions 320a-1 and 320a-2 may maintain the folding state. Referring to FIG. 3, in the unfolding state, the folding portions 320a-1 and 320a-2 may be disposed in the first segment 321 and the second segment 322. For example, the folding portions 320a-1 and 320a-2 may include the first folding portion 320a-1 in the first segment 321 and the second folding portion 320a-2 in the second segment 322. However, it is not limited thereto. For example, in the unfolding state, the heat dissipation sheet 320 may further include an additionally folded portion in addition to the folding portions 320a-1 and 320a-2 illustrated in FIG. 3.

Referring to FIG. 4, as the electronic device 101 changes from the unfolding state to the folding state, both ends of the third segment 323 may receive the tensile stress. When the first force and the second force are applied to the third segment 323, the folding portion (e.g., the folding portions 320a-1 and 320a-2 of FIG. 3) may be unfolded. For example, the first folding portion 320a-1 in the first segment 321 may be unfolded by the first force applied in the direction from the third segment 323 toward the first segment 321 in the folding state. For example, the second folding portion 320a-2 in the second segment 322 may be unfolded by the second force applied in the direction from the third segment 323 toward the second segment 322 in the folding state. The unfolded length of the first folding portion 320a-1 may be determined based on the first force. The unfolded length of the second folding portion 320a-2 may be determined based on the second force. As the folding portions 320a-1 and 320a-2 are unfolded, the heat dissipation sheet 320 may compensate without resisting the first force and the second force. The heat dissipation sheet 320 may include a material having high thermal conductivity (e.g., graphite), and the elongation ratio of the material having high thermal conductivity may be low. In case that the heat dissipation sheet 320 does not include the folding portion 320a, the heat dissipation sheet 320 may be damaged due to being elongated by the tensile stress in the folding state. According to an embodiment, the folding portion 320a may reduce damage to the heat dissipation sheet 320 by compensating for the tensile stress.

According to an embodiment, the length of the folding portions 320a-1 and 320a-2 may be determined based on the difference between the length of the heat dissipation sheet 320 in the folding state and the length of the heat dissipation sheet 320 in the unfolding state. The heat dissipation sheet 320 may effectively heat dissipate the entire area of the display 230.

According to an embodiment, the hinge bracket 255 may provide a rotation axis of the first hinge plate 252 and a rotation axis of the second hinge plate 253. For example, the hinge bracket 255 may include the first guide groove 255a that accommodates at least a portion of the first hinge plate 252 and the second guide groove 255b that accommodates at least a portion of the second hinge plate 253. The first hinge plate 252 may be rotatable along the first guide groove 255a, and the second hinge plate 253 may be rotatable along the second guide groove 255b. The hinge bracket 255 may be disposed in the hinge cover 251. For example, the hinge cover 251 may surround the hinge bracket 255.

According to an embodiment, the second hinge plate 253 may be rotatable with respect to the first hinge plate 252. Referring to FIG. 3, in the unfolding state of the electronic device 101, the first hinge plate 252 and the second hinge plate 253 may form substantially the same plane. In the folding state of the electronic device 101, the second hinge plate 253 may be spaced apart from the first hinge plate 252. The first hinge plate 252 may be coupled to the first housing 210, and the second hinge plate 253 may be coupled to the second housing 220. Although not illustrated, a link structure may be disposed between the first housing 210 and the first hinge plate 252, and between the second housing 220 and the second hinge plate 253. The first housing 210 and the second housing 220 may be rotatable to each other through the first hinge plate 252 and the second hinge plate 253.

According to an embodiment, a rotation angle range of the second housing 220 rotatable with respect to the first housing 210 may be different from a rotation angle of the second hinge plate 253 rotatable with respect to the first hinge plate 252. For example, the rotation angle range of the second housing 220 with respect to the first housing 210 may be greater than the rotation angle range of the second hinge plate 253 with respect to the first hinge plate 252.

Referring to FIG. 3, in the unfolding state, the angle between the first housing 210 and the second housing 220 may be about 180 degrees. For example, in the unfolding state, the first housing 210 and the second housing 220 may form substantially the same plane. Referring to FIG. 4, in the folding state, the first housing 210 and the second housing 220 may be disposed to face each other. For example, as the electronic device 101 changes from the unfolding state to the folding state, each of the first housing 210 and the second housing 220 may rotate by about 90 degrees.

Referring to FIG. 3, in the unfolding state, an angle between the first hinge plate 252 and the second hinge plate 253 may be about 180 degrees. For example, in the unfolding state, the first hinge plate 252 may be parallel to the first display area 231. For example, in the unfolding state, the second hinge plate 253 may be parallel to the second display area 232. Referring to FIG. 4, in the folding state, the first hinge plate 252 and the second hinge plate 253 may have an inclination with respect to the display 230. For example, the first hinge plate 252 may have an inclination with respect to the first display area 231. For example, the second hinge plate 253 may have an inclination with respect to the second display area 232. For example, the first hinge plate 252 may have an inclination of smaller than about 90 degrees with respect to the first display area 231. For example, the second hinge plate 253 may have an inclination of smaller than about 90 degrees with respect to the second display area 232. For example, as the electronic device 101 changes from the unfolding state to the folding state, each of the first hinge plate 252 and the second hinge plate 253 may rotate by an angle smaller than about 90 degrees.

According to an embodiment, in the folding state, the first direction D1 may be inclined with respect to the third direction D3 toward which the surface of the first hinge plate 252 facing the display 230 is directed. The fourth direction D4 may be referred to as a direction toward which a surface of the second hinge plate 253 directing the display 230 is directed. According to an embodiment, the second housing 220 may be rotatable within the first angle range of about 0 degrees to about 90 degrees with respect to the first housing 210. The second hinge plate 253 may be rotatable within the second angle range in an angle range smaller than about 0 degrees to about 90 degrees with respect to the first hinge plate 252. However, the above-described angle range is only exemplary, and is not limited thereto.

According to an embodiment, the state of the electronic device 101 may be changed from the unfolding state to the folding state by the movement of the first hinge plate 252 and/or the second hinge plate 253. Since the rotation angle ranges of the first hinge plate 252 and the second hinge plate 253 and the rotation angle ranges of the first housing 210 and the second housing 220 are different, the electronic device 101 according to an embodiment may provide a structure in which the curvature change of the display 230 is gentle in the folding state. For example, in case that the first hinge plate 252 and the second hinge plate 253 face each other, the curvature of the display 230 supported by the first hinge plate 252 and the second hinge plate 253 may change rapidly between the first hinge plate 252 and the second hinge plate 253. According to an embodiment, since the first hinge plate 252 and the second hinge plate 253 are inclined with respect to each other in the folding state, the curvature change of the display 230 may become gentle. Since the curvature of the display 230 is smoothly changed, damage to the display 230 may be reduced. For example, in the folding state, the formation of wrinkles may be reduced in the area (e.g., the third display area 233) where the display 230 is folded. Reducing the occurrence of the wrinkles in the third display area may contribute to reducing the stress of an area (e.g. the third display area) where said display is deformed. In that way, the durability of the display can be improved.

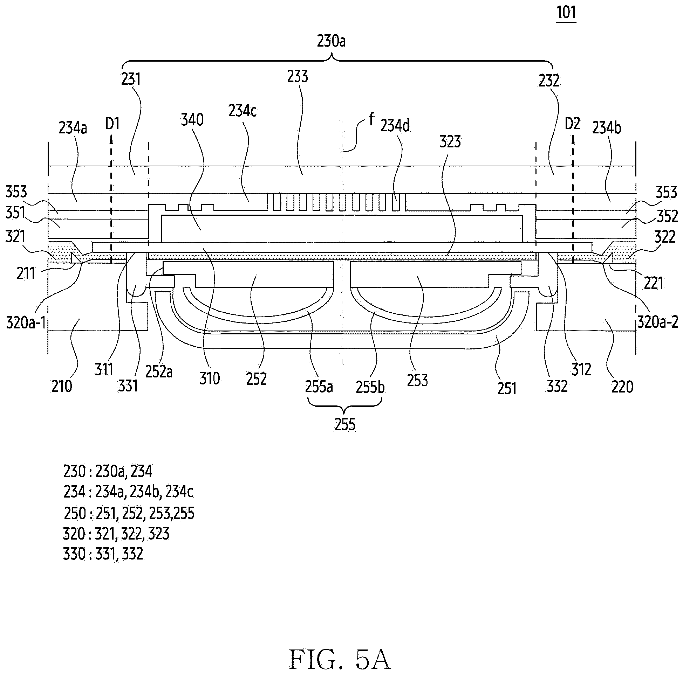

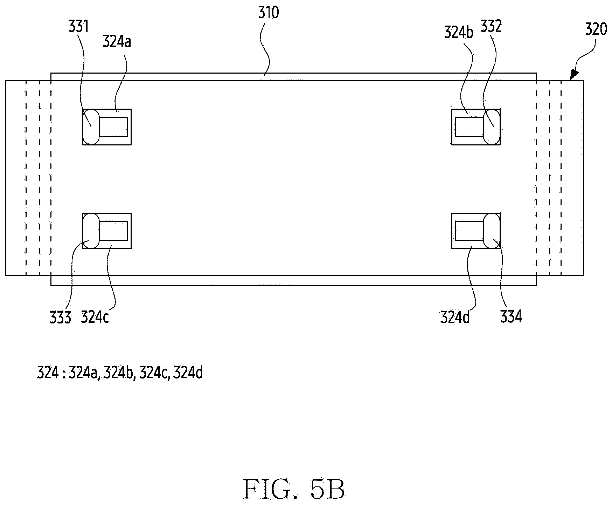

FIG. 5A schematically illustrates an exemplary electronic device. FIG. 5B is a plan view of an exemplary heat dissipation sheet.

According to one embodiment, the relative disposition structure of a heat dissipation sheet 320 and a stiffener 310 may be various. For example, as illustrated in FIG. 4, the stiffener 310 may be disposed on the hinge structure 250 and the heat dissipation sheet 320 may be disposed on the stiffener 310. However, it is not limited thereto. Referring to FIG. 5A, the heat dissipation sheet 320 may be disposed on the hinge structure 250 and the stiffener 310 may be disposed on the heat dissipation sheet 320. For example, the heat dissipation sheet 320 may be disposed between the hinge structure 250 and the stiffener 310.

According to an embodiment, in case that the stiffener 310 is disposed on the heat dissipation sheet 320, the fixing structure 330 may be disposed to pass through the heat dissipation sheet 320 in order to be connected to the stiffener 310. For example, the fixing structure 330 may pass through the heat dissipation sheet 320 and be connected to the stiffener 310 disposed on the heat dissipation sheet 320.

Referring to FIG. 5B, the heat dissipation sheet 320 may include an opening 324. The fixing structure 330 may pass through the opening 324. The opening 324 may be disposed at a position corresponding to the fixing structure 330. For example, the fixing structure 330 may include a first fixing structure 331, a second fixing structure 332, a third fixing structure 333, and/or a fourth fixing structure 334. The first fixing structure 331 and the third fixing structure 333 may be disposed closer to the first housing 210 among the first housing 210 and the second housing 220. The second fixing structure 332 and the fourth fixing structure 334 may be disposed closer to the second housing 220 among the first housing 210 and the second housing 220. The opening 324 may include a first opening 324a, a second opening 324b, a third opening 324c, and/or a fourth opening 324d. When the heat dissipation sheet 320 is viewed in a direction from the heat dissipation sheet 320 toward the stiffener 310, the first opening 324a may overlap the first fixing structure 331. The second opening 324b may overlap the second fixing structure 332. The third opening 324c may overlap the third fixing structure 333. The fourth opening 324d may overlap the fourth fixing structure 334. When the electronic device 101 is changed from the unfolding state to the folding state, the first fixing structure 331 and the third fixing structure 333 may be pressed by the first hinge plate 252, and the second fixing structure 332 and the fourth fixing structure 334 may be pressed by the second hinge plate 253. The first fixing structure 331, the second fixing structure 332, the third fixing structure 333, and/or the fourth fixing structure 334 may change the shape of the stiffener 310 when pressed by the first hinge plate 252 and the second hinge plate 253 by passing through the heat dissipation sheet 320 and being connected to the stiffener 310. The stiffener 310 may be bent by the first fixing structure 331, the second fixing structure 332, the third fixing structure 333, and/or the fourth fixing structure 334 in the folding state. According to an embodiment, the disposition structure of the stiffener 310 and the heat dissipation sheet 320 may be various.

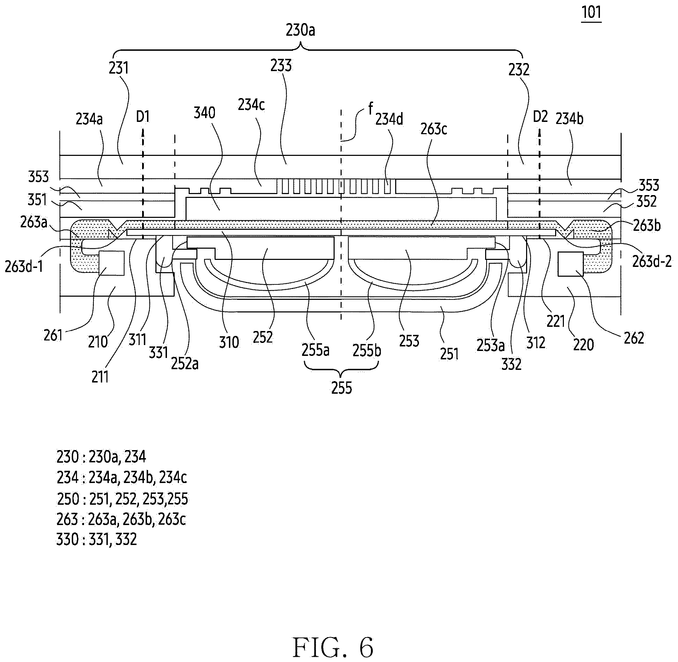

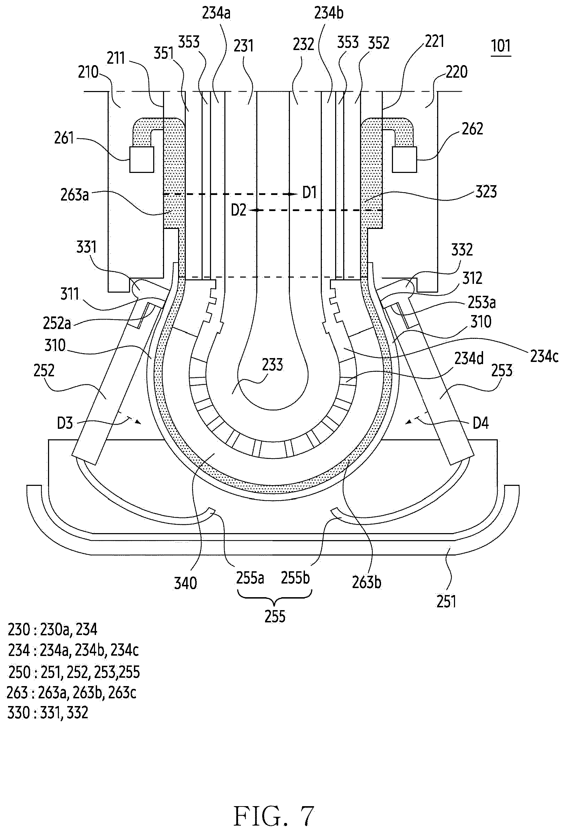

FIG. 6 schematically illustrates an exemplary electronic device in an unfolding state. FIG. 7 schematically illustrates an exemplary electronic device in a folding state.

Referring to FIGS. 6 and 7, an electronic device 101 according to an embodiment may include a flexible printed circuit board 263. The flexible printed circuit board 263 may include a plurality of conductive layers and a plurality of non-conductive layers alternately laminated with the plurality of conductive layers. The flexible printed circuit board 263 may provide electrical connections between the printed circuit board and/or various electronic components disposed outside the printed circuit board by using wires and conductive vias formed in the conductive layer. The flexible printed circuit board 263 may electrically connect a first printed circuit board 261 in a first housing 210 and a second printed circuit board 262 in a second housing 220. For example, the flexible printed circuit board 263 may be configured to transmit an electrical signal from the printed circuit board in the first housing 210 to the second printed circuit board 262. For example, the flexible printed circuit board 263 may electrically connect various electronic components disposed on the first printed circuit board 261 and various electronic components disposed on the second printed circuit board 262.

Referring to FIG. 6, the flexible printed circuit board 263 may be disposed across the first printed circuit board 261 and the second printed circuit board 262 in order to electrically connect the first printed circuit board 261 and the second printed circuit board 262. For example, the flexible printed circuit board 263 may extend from the first printed circuit board 261 in the first housing 210 to a first surface 211 of the first housing 210, cross a hinge structure 250, and extend to the second printed circuit board 262 in the second housing 220.

According to an embodiment, the flexible printed circuit board 263 may include a first segment 263a, a second segment 263b, and a third segment 263c. The first segment 263a may be connected to the first printed circuit board 261. For example, a portion of the first segment 263 a may be inserted into the first housing 210 and connected to the first printed circuit board 261, and the remaining portion of the first segment 263a may be disposed between a first display area 231 and the first surface 211. A portion of the second segment 263b may be inserted into the second housing 220 and connected to the second printed circuit board 262, and the remaining portion of the second segment 263b may be disposed between a second display area 232 and a second surface 221. The third segment 263c may be disposed between the first segment 263a and the second segment 263b. The third segment 263c may be disposed between a third display area 233 and the hinge structure 250.

According to an embodiment, the flexible printed circuit board 263 may be disposed between a stiffener 310 and the third display area 233, but is not limited thereto. For example, the flexible printed circuit board 263 may be disposed between the stiffener 310 and the hinge structure 250 (e.g., a first hinge plate 252 and a second hinge plate 253). The shape of the flexible printed circuit board 263 may be deformed according to the state of the electronic device 101. The shape of the flexible printed circuit board 263 may be deformed independently of the display 230 by the first hinge plate 252, the second hinge plate 253, a fixing structure 330, and the stiffener 310.

According to an embodiment, the third segment 263c may overlap the hinge structure 250. For example, the third segment 263c may be connected from the first segment 263a across the hinge structure 250 to the second segment 263b. Since the third segment 263c overlaps the hinge structure 250, the shape of the third segment 263c in the unfolding state and the shape of the third segment 263c in the folding state may be different. For example, in the unfolding state, the third segment 263c may be disposed on substantially the same plane as the first segment 263a and the second segment 263b. In the unfolding state, since the first segment 263a and the second segment 263b form substantially the same plane, the first segment 263a, the second segment 263b, and the third segment 263c may be flat.

Referring to FIG. 6, when the electronic device 101 is in the folding state, the flexible printed circuit board 263 may be flat. Referring to FIG. 7, when the electronic device 101 is changed from the unfolding state to the folding state, the flexible printed circuit board 263 may be bent by being pressed by the fixing structure 330. For example, in the folding state, the first hinge plate 252 and the second hinge plate 253 may press the fixing structure 330. The fixing structure 330 may press the stiffener 310 by being pressed from the first hinge plate 252 and the second hinge plate 253. The stiffener 310 may be bent by the force, and the third segment 263c of the flexible printed circuit board 263 in contact with the stiffener 310 may also be bent. When the device 101 is changed from the folding state to the unfolding state, the stiffener 310 may become flat again by restoring force. As the stiffener 310 becomes flat, the third segment 263c may also become flat.

According to an embodiment, the flexible printed circuit board 263 may receive tensile stress in the unfolding state. Since the third segment 263c is bent in the folding state, a first force in the direction toward the first segment 263a may be applied to a portion of the third segment 263c connected to the first segment 263a, and a second force in the direction toward the second segment 263b may be applied to a portion of the third segment 263c connected to the second segment 263b.

According to an embodiment, the flexible printed circuit board 263 may include folding portions 263d-1 and 263d-2 to compensate for the first force and the second force. For example, when the electronic device 101 is in the unfolding state, the folding portions 263d-1 and 263d-2 may maintain a folded state. Referring to FIG. 6, the folding portions 263d-1 and 263d-2 may be disposed in the first segment 263a and the second segment 263b in the unfolding state. For example, the folding portions 263d-1 and 263d-2 may include a first folding portion 263d-1 in the first segment 263a and a second folding portion 263d-2 in the second segment 263b. However, it is not limited thereto. For example, in the unfolding state, the flexible printed circuit board 263 may further include an additionally folded portion in addition to the folding portions 263d-1 and 263d-2 illustrated in FIG. 6.

Referring to FIG. 7, as the electronic device 101 is changed from the unfolding state to the folding state, both ends of the third segment 263c may receive the tensile stress. When the first force and the second force are applied to the third segment 263c, the folding portions 263d-1 and 263d-2 may be unfolded. For example, the first folding portion 263d-1 in the first segment 263a may be unfolded by the first force applied in the direction from the third segment 263c toward the first segment 263a in the folding state. For example, the second folding portion 263d-2 in the second segment 263b may be unfolded by the second force applied in the direction from the third segment 263c toward the second segment 263b in the folding state. The unfolded length of the first folding portion 263d-1 may be determined based on the first force. The unfolded length of the second folding portion 263d-2 may be determined based on the second force. As the folding portions 263d-1 and 263d-2 are unfolded, the flexible printed circuit board 263 may compensate without resisting the first force and the second force. In case that the flexible printed circuit board 263 does not include the folding portions 263d-1 and 263d-2, since the flexible printed circuit board 263 is elongated by the tensile stress in the folding state, it may be damaged. The folding portions 263d-1 and 263d-2 may reduce damage to the flexible printed circuit board 263 by compensating for the tensile stress. According to an embodiment, the folding portions 263d-1 and 263d-2 may reduce damage to the printed circuit board 263 by compensating for the tensile stress. In that way, the stress on said component (e.g. the printed circuit board 263) will be reduced and the durability of the component can be improved. According to an embodiment, the flexible printed circuit board 263 may stably connect the first printed circuit board 261 and the second printed circuit board 262.

The electronic device 101 illustrated in FIGS. 3 and 4 is illustrated as including the heat dissipation sheet 320, and the electronic device 101 illustrated in FIGS. 5 and 6 is illustrated as including the flexible printed circuit board 263, but is not limited thereto. For example, the electronic device 101 according to an embodiment may include both the heat dissipation sheet 320 and the flexible printed circuit board 263.

An electronic device (e.g., an electronic device 101 of FIG. 3) according to an embodiment may comprise a first housing (e.g., a first housing 210 of FIG. 3), a second housing (e.g., the second housing 320 of FIG. 3), a hinge structure (e.g., a hinge structure 250 of FIG. 3), a display (e.g., a display 230 of FIG. 3), a heat dissipation sheet (e.g., a heat dissipation sheet 320 of FIG. 3), a stiffener (e.g., a stiffener 310 of FIG. 3), and a fixing structure (e.g., a fixing structure 330 of FIG. 3). The first housing may comprise a first surface (e.g., a first surface 211 of FIG. 3). The second housing may comprise a second surface (e.g., a second surface 221 of FIG. 3). The second housing may be rotatable with respect to the first housing. The hinge structure may comprise a first hinge plate (e.g., a first hinge plate 252 of FIG. 3) and a second hinge plate (e.g., a second hinge plate 253 of FIG. 3). The second hinge plate may be rotatable with respect to the first hinge plate. The display may include a first display area (e.g., a first display area 231 of FIG. 3), a second display area (e.g., a second display area 232 of FIG. 3), and a third display area (e.g., a third display area 233 of FIG. 3). The first display area may be disposed on the first housing. The second display area may be disposed on the second housing. The third display area may be disposed on the hinge structure. The heat dissipation sheet may include a first segment (e.g., a first segment 321 of FIG. 3), a second segment (e.g., a second segment 322 of FIG. 3), and a third segment (e.g., a third segment 323 of FIG. 3). The first segment may be disposed between the first display area and the first surface. The second segment may be disposed between the second display area and the second surface. The third segment may be disposed between the third display area and the hinge structure. The stiffener may be disposed between the third display area and the hinge structure. The stiffener may provide rigidity to the third display area. The fixing structure may be connected to the stiffener. The fixing structure may be pressed by the first hinge plate and the second hinge plate in a folding state in which a first direction (e.g., a first direction D1 of FIG. 4) towards which the first surface is directed and a second direction (e.g., a second direction D2 of FIG. 4) towards which the second surface 221 are directed are opposite. The stiffener may be flat in an unfolding state in which the first direction and the second direction are the same. At least a portion of the stiffener may be bent by the force applied to the fixing structure from the first hinge plate and the second hinge plate in the folding state. According to an embodiment of the present disclosure, the stiffener may provide rigidity to the third display area. A shape of the stiffener may be deformed to correspond to a shape of the third display area as the first hinge plate and the second hinge plate are pressed by the fixing structure. The stiffener may provide rigidity to the third display area by being deformed independently of the display. According to an embodiment, the heat dissipation sheet may effectively heat dissipate the display by corresponding to the entire area of the display.

According to an embodiment, the fixing structure may be space apart from a side surface (e.g., a side surface 252a of FIG. 3) of the first hinge plate facing the fixing structure and a side surface (e.g., a side surface 253a of FIG. 3) of the second hinge plate facing the fixing structure in the unfolding state in which the first direction and the second direction are the same. The fixing structure may be in contact with the side surface of the first hinge plate and the side surface of the second hinge plate in the folding state. According to an embodiment of the present disclosure, the fixing structure is spaced apart from the first hinge plate and the second hinge plate in an unfolding state, and thus may not be pressed. In the unfolding state, the stiffener may be flat. In the folding state, the fixing structure may be pressed from the first hinge plate and the second hinge plate. Since the fixing structure is coupled to the stiffener, the stiffener may be bent by a force transmitted from the first hinge plate and the second hinge plate. The stiffener may provide rigidity to the third display area by corresponding to the third display area when the electronic device is in the unfolding state or the folding state.

An electronic device according to an embodiment may further comprise a first fixing structure (e.g., a first fixing structure 331 of FIG. 3) and a second fixing structure (e.g., a second fixing structure 332 of FIG. 3). The first fixing structure may be connected to the stiffener. The first fixing structure may be disposed between the first housing and the first hinge plate. The second fixing structure may be connected to the stiffener. The second fixing structure may be disposed between the second housing and the second hinge plate. The first fixing structure may be spaced apart from the first hinge plate in the unfolding state. The first fixing structure may be pressed by the first hinge plate in the folding state. The second fixing structure may be spaced apart from the second hinge plate in the unfolding state. The second fixing structure may be pressed by the second hinge plate in the folding state. According to an embodiment of the present disclosure, the first fixing structure may be pressed by the first hinge plate, and the second fixing structure may be pressed by the second hinge plate. The first fixing structure and the second fixing structure may bend the stiffener by pressing the stiffener in different directions in the folding state. A shape of the stiffener may be a waterdrop shape in the folding state, but is not limited thereto.

According to an embodiment, the heat dissipation sheet may comprise a folding portion (e.g., folding portions 320a-1 and 320a-2 of FIG. 3). The folding portion may be disposed in the first segment and the second segment. The folding portion may be folded in the unfolding state. The folding portion may be unfolded when the electronic device is changed from the unfolding state to the folding state. According to an embodiment of the present disclosure, in the folding state, the heat dissipation sheet may receive tensile stress. In case that the length of the heat dissipation sheet is fixed, the heat dissipation sheet may be elongated while resisting the tensile stress when the tensile stress is applied. The heat dissipation sheet may be damaged by being elongated. According to an embodiment, the folding portion may compensate for the tensile stress in the folding state. The folding portion may maintain a folded state in the unfolding state, and the folding portion may compensate for tensile stress by being unfolded in the folding state. According to an embodiment, since damage to the heat dissipation sheet may be reduced, the heat dissipation sheet may effectively heat dissipate the display.

According to an embodiment, a shape of the heat dissipation sheet corresponds to the shape of the display. According to an embodiment of the present disclosure, the heat dissipation sheet may include a first segment corresponding to a first display area, a second segment corresponding to a second display area, and a third segment corresponding to a hinge structure. The third segment may thermally connect the first segment and the second segment. According to an embodiment, the heat dissipation sheet may effectively heat dissipate the entire display area.

According to an embodiment, the hinge structure may comprise a hinge bracket (e.g., a hinge bracket 255 of FIG. 3). The hinge bracket may comprise a first guide groove (e.g., a first guide groove 255a of FIG. 3) and a second guide groove (e.g., a second guide groove 255b of FIG. 3). The first guide groove may be slidably connected to the first hinge plate. The second guide groove may be slidably connected to the second hinge plate.

According to an embodiment, the second housing may be rotatable within a first angle range with respect to the first housing. The second hinge plate may be rotatable with respect to the first hinge plate within a second angle range smaller than the first angle range.

According to an embodiment, the first direction may be inclined with respect to a third direction in which the surface of the first hinge plate directing the display is directed in the folding state. According to an embodiment of the present disclosure, since the first hinge plate and the second hinge plate are inclined with respect to each other in the folding state, a change in curvature of the display may become gentle. Since the curvature of the display is smoothly changed, damage to the display may be reduced. For example, in the folding state, the formation of wrinkles may be reduced in the area (e.g., the third display area) where the display is folded. Reducing the damage on an area of the display may contribute to reducing the stress of the area where said display is deformed. In that way, the durability of the display can be improved.

The electronic device according to an embodiment may further comprise a first support plate (e.g., a first support plate 351 of FIG. 3) and a second support plate (e.g., a second support plate 352 of FIG. 3). The first support plate may be disposed between the first display area and the first surface. The first support plate may support the first display area. The second support plate may be disposed between the second display area and the second surface. The second support plate may support the second display area. The first segment may be disposed between the first surface and the first support plate. The second segment may be disposed between the second surface and the second support plate.

The electronic device according to an embodiment may further comprise a leveler (e.g., a leveler 340 of FIG. 3). The leveler may be disposed between the first support plate and the second support plate. According to an embodiment of the present disclosure, the first display area and the second display area may be supported by the first support plate and the second support plate, respectively. The first display area may correspond to the first housing, and the second display area may correspond to the second housing. The first support plate may support the first display area between the first housing and the first display area. The second support plate may support the second display area between the second housing and the second display area. The leveler may compensate for a step between the first support plate and the second support plate.

According to an embodiment, the stiffener may be disposed on the hinge structure. The heat dissipation sheet may be disposed on the stiffener.

According to an embodiment, the stiffener may be disposed on the hinge structure. The stiffener may be disposed on the heat dissipation sheet.

According to an embodiment, the heat dissipation sheet may comprise an opening (e.g., the opening 324 of FIG. 3). The fixing structure may be coupled to the stiffener by passing through the opening. According to an embodiment of the present disclosure, the relative disposition structure of the heat dissipation sheet and the stiffener may be various. In case that the heat dissipation sheet may be disposed on the hinge structure and the stiffener is disposed on the heat dissipation sheet, the fixing structure may be coupled to the stiffener through the opening of the heat dissipation sheet. According to an embodiment, various types of designs of the electronic device may be possible.

According to an embodiment, the stiffener may be flattened by the restoring force of the stiffener when the electronic device is changed from the folding state to the unfolding state. According to an embodiment of the present disclosure, when the electronic device is changed from the folding state to the unfolded state, the stiffener may be flattened by the restoring force independently of a display.

According to an embodiment, the stiffener may be attached to the heat dissipation sheet. According to an embodiment of the present invention, the stiffener may be attached to the heat dissipation sheet, and thus the shape of the heat dissipation sheet may also be deformed when the shape of the stiffener is deformed.

An electronic device (e.g., an electronic device 101 of FIG. 3) according to an embodiment may comprise a first housing (e.g., a first housing 210 of FIG. 3), a second housing (e.g., a second housing 320 of FIG. 3), a hinge structure (e.g., a hinge structure 250 of FIG. 3), a display (e.g., a display 230 of FIG. 3), a flexible printed circuit board (e.g., a flexible printed circuit board 263 of FIG. 6), a stiffener (e.g., a stiffener 310 of FIG. 3), and a fixing structure (e.g., a fixing structure 330 of FIG. 3). The first housing may comprise a first surface (e.g., a first surface 211 of FIG. 3). The second housing may comprise a second surface (e.g., a second surface 221 of FIG. 3). The second housing may be rotatable with respect to the first housing. The hinge structure may comprise a hinge bracket (e.g., a hinge bracket 255 of FIG. 3), a first hinge plate (e.g., a first hinge plate 252 of FIG. 3), and a second hinge plate (e.g., a second hinge plate 253 of FIG. 3). The hinge bracket may comprise a first guide groove (e.g., a first guide groove 255a of FIG. 3) and a second guide groove (e.g., a second guide groove 255b of FIG. 3). The first hinge plate may be slidably connected to the first guide groove. The second hinge plate may be slidably connected to the second guide groove different from the first guide groove. The display may comprise a first display area (e.g., a first display area 231 of FIG. 3), a second display area (e.g., a second display area 232 of FIG. 3), and a third display area (e.g., a third display area 233 of FIG. 3). The first display area may be disposed on the first housing. The second display area may be disposed on the second housing. The third display area may be disposed on the hinge structure. The flexible printed circuit board may comprise a first segment (e.g., a first segment 263a of FIG. 6), a second segment (e.g., a second segment 263b of FIG. 6), and a third segment (e.g., a third segment 263c of FIG. 6). The first segment may extend from a first printed circuit board (e.g., a first printed circuit board 261 of FIG. 6) in the first housing to between the first display area and the first surface. The second segment may extend from a second printed circuit board (e.g., a second printed circuit board 262 of FIG. 6) in the second housing to between the second display area and the second surface. The third segment may be disposed between the first segment and the second segment. The third segment may be disposed between the third display area and the hinge structure. The stiffener may be disposed between the third display area and the hinge structure. The stiffener may provide rigidity to the third display area. The fixing structure may be connected to the stiffener. The fixing structure may be pressed by the first hinge plate and the second hinge plate in a folding state in which a first direction (e.g., a first direction D1 of FIG. 4) towards which the first surface is directed and a second direction (e.g., a second direction D2 of FIG. 4) towards which the second surface are directed are opposite. The stiffener may be flat in an unfolding state in which the first direction and the second direction are the same. At least a portion of the stiffener may be bent by the force applied to the fixing structure from the first hinge plate and the second hinge plate in the folding state. According to an embodiment of the present disclosure, the stiffener may provide rigidity to the third display area. A shape of the stiffener may be deformed to correspond to a shape of the third display area as the first hinge plate and the second hinge plate are pressed by the fixing structure. The stiffener may provide rigidity to the third display area by being deformed independently of the display.

According to an embodiment, the fixing structure may be space apart from a side surface (e.g., a side surface 252a of FIG. 3) of the first hinge plate facing the fixing structure and a side surface (e.g., a side surface 252b of FIG. 3) of the second hinge plate facing the fixing structure in the unfolding state in which the first direction and the second direction are the same. The fixing structure may be in contact with the side surface of the first hinge plate and the side surface of the second hinge plate in the folding state. According to an embodiment of the present disclosure, the fixing structure is spaced apart from the first hinge plate and the second hinge plate in an unfolding state, and thus may not be pressed. In the unfolding state, the stiffener may be flat. In the folding state, the fixing structure may be pressed from the first hinge plate and the second hinge plate. Since the fixing structure is coupled to the stiffener, the stiffener may be bent by a force transmitted from the first hinge plate and the second hinge plate. The stiffener may provide rigidity to the third display area by corresponding to the third display area when the electronic device is in the unfolding state or the folding state.

The electronic device according to an embodiment may further comprise a first fixing structure (e.g., a first fixing structure 331 of FIG. 6) and a second fixing structure (e.g., a second fixing structure 332 of FIG. 6). The first fixing structure may be connected to the stiffener. The first fixing structure may be disposed between the first housing and the first hinge plate. The second fixing structure may be connected to the stiffener. The second fixing structure may be disposed between the second housing and the second hinge plate. The first fixing structure may be spaced apart from the first hinge plate in the unfolding state. The first fixing structure may be pressed by the first hinge plate in the folding state. The second fixing structure may be spaced apart from the second hinge plate in the unfolding state. The second fixing structure may be pressed by the second hinge plate in the folding state. According to an embodiment of the present disclosure, the first fixing structure may be pressed by the first hinge plate, and the second fixing structure may be pressed by the second hinge plate. The first fixing structure and the second fixing structure may bend the stiffener by pressing the stiffener in different directions in the folding state. A shape of the stiffener may be a waterdrop shape in the folding state, but is not limited thereto.

According to an embodiment, the flexible printed circuit board may comprise a folding portion (e.g., folding portions 263d-1 and 263d-2 of FIG. 6). The folding portion may be disposed in the first segment and the second segment. The folding portion may be folded in the unfolding state. The folding portion may be unfolded when the electronic device is changed from the unfolding state to the folding state. According to an embodiment of the present disclosure, in the folding state, the flexible printed circuit board may receive tensile stress. In case that the flexible printed circuit board does not include the folding portion, the flexible printed circuit board may be elongated while resisting the tensile stress when the tensile stress is applied. The flexible printed circuit board may be damaged by being elongated. According to an embodiment, the folding portion may compensate for the tensile stress in the folding state. The folding portion may maintain a folded state in the unfolding state, and the folding portion may compensate for tensile stress by being unfolded in the folding state. According to an embodiment, damage to the flexible printed circuit board may be reduced.

According to an embodiment, the first direction may be inclined with respect to a third direction in which the surface of the first hinge plate directing the display is directed in the folding state. According to an embodiment of the present disclosure, since the first hinge plate and the second hinge plate are inclined with respect to each other in the folding state, a change in curvature of the display may become gentle. Since the curvature of the display is gently changed, damage to the display may be reduced. For example, in the folding state, the formation of wrinkles may be reduced in the area (e.g., the third display area) where the display is folded.

The electronic device according to various embodiments disclosed in the present document may be various types of devices. The electronic device may include, for example, a portable communication device (e.g., a smartphone), a computer device, a portable multimedia device, a portable medical device, a camera, a wearable device, or a home appliance. The electronic device according to an embodiment of the present document is not limited to the above-described devices.

The various embodiments and terms used herein are not intended to limit the technical features described herein to specific embodiments and should be understood to include various modifications, equivalents, or substitutes of the embodiment. With respect to the description of the drawings, similar reference numerals may be used for similar or related components. The singular form of the noun corresponding to the item may include one or more of the items unless clearly indicated differently in a related context. In this document, each of the phrases such as "A or B", "at least one of A and B", "at least one of A, B and C", "at least one of A, B, or C", and "at least one of A, B, or C" may include any one of the phrases together, or all possible combinations thereof. Terms such as "first", "second", or "second", or "second" may be used simply to distinguish a corresponding component from another corresponding component, and are not limited to other aspects (e.g., importance or order). When some (e.g., the first) component is referred to as "coupled" or "connected" in another (e.g., the second) component, with or without the term "functional" or "communicatively", it means that some of the components can be connected directly (e.g., wired), wirelessly, or through a third component.

The term "module" used in various embodiments of the present document may include a unit implemented in hardware, software, or firmware and be used interchangeably with terms such as logic, logic block, component, or circuitry, for example. The module may be a minimum unit or a part of the integrally configured component or the component that performs one or more functions. For example, according to an embodiment, the module may be implemented in the form of an application-specific integrated circuit (ASIC).

Various embodiments of the present document may be implemented as software (e.g., a program) including one or more instructions stored in a storage medium (or external memory) readable by a device (e.g., the electronic device 100). For example, a processor of a device (e.g., the electronic device 100) may call and execute at least one of the one or more instructions stored from a storage medium. This makes it possible for the device to operate to perform at least one function according to at least one command called. The one or more instructions may include code generated by a compiler or code that may be executed by an interpreter. The device-readable storage medium may be provided in the form of a non-transitory storage medium. Here, the term 'non-transitory' only means that a storage medium is a device that is tangible and does not include a signal (e.g., electromagnetic wave), and the term does not distinguish between a case where data is semi-permanently stored and a case where it is temporarily stored.

According to an embodiment, a method according to various embodiments disclosed in the present document may be provided by being included in a computer program product. The computer program products may be traded between sellers and buyers as products. The computer program products may be distributed in the form of device-readable storage media (e.g., compact disc read only memory (CD-ROM), or distributed (e.g., downloaded or uploaded) directly or online through an application store (e.g., Play Store^{™}) or between two user devices (e.g., smartphones). In the case of online distribution, at least some of the computer program products may be temporarily stored or temporarily created on a device-readable storage medium such as a manufacturer's server, a server in an application store, or a memory in a relay server.

According to various embodiments, each of the above-described components (e.g., a module or a program) may include a single object or a plurality of obj ects, and some of the plurality of objects may be separated and disposed in other components. According to various embodiments, one or more components or operations of the above-described corresponding components may be omitted, or one or more other components or operations may be added. Alternatively, or additionally, a plurality of components (e.g., modules or programs) may be integrated into one component. In this case, the integrated component may perform one or more functions of each of the components in the same or similar manner as those performed by the corresponding component among the plurality of components before the integration. According to various embodiments, operations performed by a module, a program, or other components may be executed sequentially, in parallel, repeatedly, or heuristic, performed in a different order, omitted, or one or more other operations may be added.

## Claims

1. An electronic device (101) comprising:
a first housing (210) comprising a first surface (211);
a second housing (220) comprising a second surface (221) and rotatable with respect to the first housing (210);
a hinge structure (250) comprising a first hinge plate (252) and a second hinge plate (253) rotatable with respect to the first hinge plate (252);
a display (230) comprising:
a first display area (231) disposed on the first housing (210),
a second display area (232) disposed on the second housing (220), and
a third display area (233) disposed on the hinge structure (250);
a heat dissipation sheet (320) comprising:
a first segment (321) disposed between the first display area (231) and the first surface (211),
a second segment (322) disposed between the second display area (232) and the second surface (221), and
a third segment (323) disposed between the third display area (233) and the hinge structure (250);
a stiffener (310) disposed between the third display area (233) and the hinge structure (250), and providing rigidity to the third display area (233);
a fixing structure (330) connected to the stiffener (310), wherein the fixing structure (330) is pressed by the first hinge plate (252) and the second hinge plate (253) in a folding state in which a first direction (D1) towards which the first surface (211) is directed and a second direction D2 towards which the second surface (221) are directed are opposite,
wherein the stiffener (310) is flat in an unfolding state in which the first direction (D1) and the second direction (D2) are the same,
wherein at least a portion of the stiffener (310) is bent by the force applied to the fixing structure (330) from the first hinge plate (252) and the second hinge plate (253) in the folding state.

2. The electronic device (101) of claim 1,
wherein the fixing structure (330) is space apart from a side surface (252a) of the first hinge plate (252) facing the fixing structure (330) and a side surface (253a) of the second hinge plate (253) facing the fixing structure (330) in the unfolding state,
wherein the fixing structure (330) is in contact with the side surface (252a) of the first hinge plate (252) and the side surface (253a) of the second hinge plate (253) in the folding state.

3. The electronic device (101) of claim 2,
wherein the fixing structure (330) comprising:
a first fixing structure (331) connected to the stiffener (310) and disposed between the first housing (210) and the first hinge plate (252); and
a second fixing structure (332) connected to the stiffener (310) and disposed between the second housing (220) and the second hinge plate (253),
wherein the first fixing structure (331) is spaced apart from the first hinge plate (252) in the unfolding state, and is pressed by the first hinge plate (252) in the folding state,
wherein the second fixing structure (332) is spaced apart from the second hinge plate (253) in the unfolding state, and is pressed by the second hinge plate (253) in the folding state.

4. The electronic device (101) of any one of claims 1 to 3,
wherein the heat dissipation sheet (320) comprises a folding portion (320a-1; 320a-2) folded in the unfolding state, wherein the folding portion (320a-1; 320a-2) is disposed in the first segment (321) and the second segment (322),
wherein the folding portion (320a-1; 320a-2) is unfolded when the electronic device (101) is changed from the unfolding state to the folding state.

5. The electronic device (101) of any one of claims 1 to 4,
wherein a shape of the heat dissipation sheet (320) corresponds to the shape of the display (230).

6. The electronic device (101) of any one of claims 1 to 5,
wherein the hinge structure (250) comprises a hinge bracket (255),
wherein the hinge bracket (255) comprises a first guide groove (255a) to which the first hinge plate (252) is slidably connected, and a second guide groove (255b) to which the second hinge plate (253) is slidably connected.

7. The electronic device (101) of any one of claims 1 to 6,
wherein the second housing (220) is rotatable within a first angle range with respect to the first housing (210),
wherein the second hinge plate (253) is rotatable with respect to the first hinge plate (252) within a second angle range smaller than the first angle range.

8. The electronic device (101) of any one of claims 1 to 7,
wherein the first direction (D1) is inclined with respect to a third direction (D3) in which the surface of the first hinge plate (252) facing the display (230) is directed in the folding state.

9. The electronic device (101) of any one of claims 1 to 8, further comprising:
a first support plate (351) disposed between the first display area (231) and the first surface (211), and supporting the first display area (231); and
a second support plate (352) disposed between the second display area (232) and the second surface (221), and supporting the second display area (232)
wherein the first segment (321) is disposed between the first surface (211) and the first support plate (351),
wherein the second segment (322) is disposed between the second surface (221) and the second support plate (352).

10. The electronic device (101) of claim 9, further comprising:
a leveler (340) disposed between the first support plate (351) and the second support plate (352).

11. The electronic device (101) of any one of claims 1 to 10,
wherein the stiffener (310) is disposed on the hinge structure (250),
wherein the heat dissipation sheet (320) is disposed on the stiffener (310).

12. The electronic device (101) of any one of claims 1 to 11,
wherein the heat dissipation sheet (320) is disposed on the hinge structure (250) and wherein the stiffener (310) is disposed on the heat dissipation sheet (320).

13. The electronic device (101) of claim 12,
wherein the heat dissipation sheet (320) comprises an opening (324),
wherein the fixing structure (330) is coupled to the stiffener (330) by passing through the opening (324).

14. The electronic device (101) of any one of claims 1 to 13,
wherein the stiffener (310) is flattened by the restoring force of the stiffener (310) when the electronic device (101) is changed from the folding state to the unfolding state.

15. The electronic device (101) of any one of claims 1 to 14, further comprising:
a flexible printed circuit board (263) comprising:
a first segment (263a) extending from a first printed circuit board (261) in the first housing (210) between the first display area (231) and the first surface (211),
a second segment (263b) extending from a second printed circuit board (262) in the second housing (220) between the second display area (232) and the second surface (221), and
a third segment (263c) disposed between the first segment (263a) and the second segment (263b), and disposed between the third display area (233) and the hinge structure (250).
